Europäisches Patentamt

European Patent Office

Office européen des brevets

(11) Publication number: **0 213 670**

**A2**

(12) **EUROPEAN PATENT APPLICATION**

(21) Application number: **86201418.0**

(22) Date of filing: **12.08.86**

(51) Int. Cl.⁴: **G 06 F 15/60**

(30) Priority: **19.08.85 BE 2060764**

(43) Date of publication of application:
**11.03.87 Bulletin 87/11**

(84) Designated Contracting States:
**AT BE CH DE FR GB IT LI LU NL SE**

(71) Applicant: **BELL TELEPHONE MANUFACTURING COMPANY Naamloze Vennootschap Francis Wellesplein 1 B-2018 Antwerp(BE)**

(84) Designated Contracting States:
**BE LU NL**

(71) Applicant: **International Standard Electric Corporation New York 320 Park Avenue New York 22, NY(US)**

(84) Designated Contracting States:
**CH DE FR GB IT LI SE AT**

(72) Inventor: **Van der Loock, Johannes Koppellandstraat 75 B-2410 Herentals(BE)**

(72) Inventor: **Guebels, Pierre-Paul François M.M. Ridder Gerardilaan 53 B-2520 Edegem(BE)**

(74) Representative: **Vermeersch, Robert et al, BELL TELEPHONE MANUFACTURING COMPANY Naamloze Vennootschap Patent Department Francis Wellesplein 1 B-2018 Antwerp(BE)**

(54) Computer aided design system.

(57) Computer aided design system for building up a chip in hierarchical levels with functional cells, having a data base (DB) including for each cell at least one definition data block (DC2, DPOL2, DBOL2, DT2) determining the definition of said cell and exclusively storing data which define said cell and are independent from its placement in said other cell, and at least one instance data block (DCI21) defining the instance of said cell and exclusively storing data which are dependent from said placement.

./...

FIG.3

- 1 -

## COMPUTER AIDED DESIGN SYSTEM

The present invention relates to a computer aided design system for a device, e.g. chip, including a display unit and a computer having a memory storing a data base, said system enabling said device to be built up in hierarchical levels by means of a plurality of functional cells and such that each cell, except one, is placed in another cell.

Such a system is generally known in the art, e.g. from :

- the book "Introduction to VLSI systems" by C. Mead and L. Conway, Addison - Wesley Publishing Company and particularly from the chapter "An interactive layout system" pp. 109 - 115;

- the article "Methodologies for Full Custom VLSI Design" by J. Danneels et al, Electrical Communication, Vol. 58, No. 4, 1984, pp. 389 - 397;

- the article "Computer-aided engineering/design workstations" by E. Freeman, EDN May 30, 1985, pp. 141 - 156; and

- the article "Transforming a simulated IC into silicon demands tools that unravel design decisions" by M. Schindler, Electronic Design, December 13, 1984, pp. 118 - 132.

This last article on page 132 stresses the importance of the organization of the data base since this has a direct influence on the performance, e.g. speed and reliability, and the expandability of the system.

Therefore, an object of the present invention is to provide a system of the above type wherein the data base is organized in such a way that modifications made in the course of a design only require small changes in the data base so that they may be performed relatively fast and in a reliable way.

According to the invention this object is achieved due to the fact that said data base includes, for each cell, at least one definition data block, determining the definition of said cell and exclusively storing data which define said cell and are independent from its placement in said other cell, and at least one instance data block defining the instance of said cell and exclusively storing data which are dependent from said placement.

In this way, for a large number of design operations, only the instance data blocks have to be changed. For instance, when the placement of a cell in another cell is modified, for the first mentioned cell only the instance data block has to be updated.

Another characteristic feature of the present system is that the data stored in said instance data block relate to the name of the instance, the position and orientation of said cell instance in said other cell and a pointer to the definition data block of said other cell.

Because the amount of data stored in each instance data block is small, a change of these data is a very reliable operation which can be executed in a relatively short time.

A further characteristic feature of the present system is that a number of definition data blocks is associated to each cell definition, and that in respective ones of said blocks data are stored concerning the cell definition proper, the outline of said cell definition, the terminals on said outline and the junction points and connections inside said outline, all said parameters being determined with respect to the cell itself.

When as in the above example the placement of a cell in another cell is modified, for the other cell only the data relating to the junction points and the connections need to be modified.

The invention also relates to a computer aided design system for a device, e.g. a chip, including a display unit, a computer with a memory and means to display a point on said display unit and to enter the coordinates of said point in said memory, said system being able to create and display one or more first polygon-shaped cells in a second polygon-shaped cell and said cells being constituted by perpendicular line segments.

An object of the invention is to provide a system of the type just described which makes it possible to identify a first cell in a simple way.

According to the invention this object is achieved due to the fact that said system is adapted to first subdivide each of said first cells in one or more inner rectangles and to store the coordinates of the vertices of a diagonal of each rectangle in memory and then to compare said coordinates with those of said point until the rectangle and therefore the first cell is possibly found wherein said point is located.

Without subdivision into rectangles it would be necessary to compare the coordinates of the point with those of the vertices of the polygon-shaped first cells and this might be a lengthy operation when these polygons have a complex shape.

The above mentioned and other objects and features of the invention will become more apparent and the invention itself will be best understood by referring to the following description of an embodiment taken in conjunction with the accompanying drawings wherein:

Fig. 1 is a schematic view of a computer aided design system according to the invention for the design of a device, e.g. a chip;

Fig. 2 represents the two upper levels of a hierarchical plan of a multilayer chip realised by means of the system of Fig. 1 and as visible on the display unit DU of this figure;

Figs. 3 to 5 schematically represent the data base DB of Fig. 1.

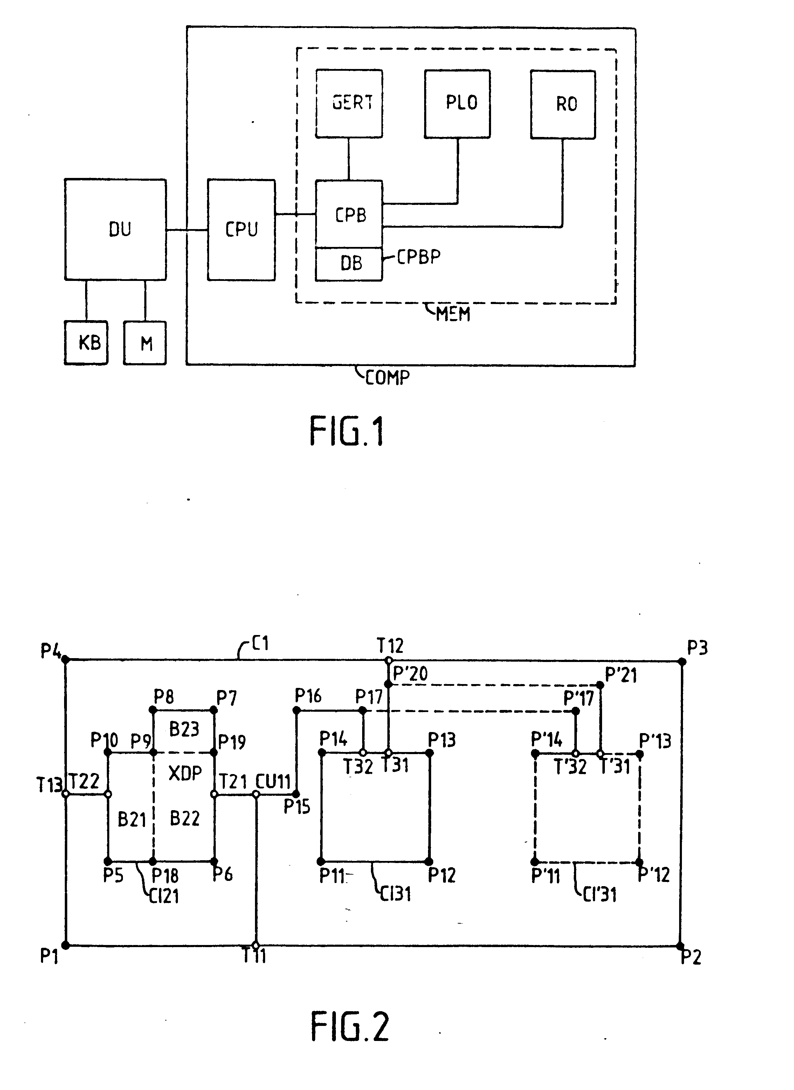

The computer aided design system represented in Fig. 1 for the design of a device, more particularly of a chip, includes a computer COMP and a display unit DU with an associated keyboard KB and a pointing device or mouse M. The computer COMP comprises a processing unit CPU, coupled to the display unit DU, and a memory MEM storing a chip planner and builder programme CPBP comprising a code CPB and a data base DB, a graphics editor programme GERT, a procedural layout programme PLO and a routing programme RO. The latter programmes GERT, PLO and RO are able to work in cooperation with the programme CPBP, as will be explained later.

The programme CPBP is an interactive programme which allows a user to interact with the system through the keyboard KB and with the mouse M which controls the position of a cursor on the DU. By operating a button on the mouse M the coordinates of a point designated by the cursor on the DU are entered in the memory MEM. This operation is called digitizing. Menus of instructions and parameters are displayed on the DU and the programme asks the user for additional information whenever this is required.

The CPBP allows a user during a chip planning phase to realise and display on the unit DU the plan of a multi-layer chip in hierarchical levels and from the highest to the lowest level, and then to make the real layout of the thus planned chip during a following chip building phase. This is done from the lowest to the highest level. More particularly, the programme CPBP allows the plan of the chip to be realised by means of functional cells which are so arranged in a plurality of levels that the cell of highest level is the chip itself and that a cell of any other level forms part of a cell of the immediately higher level. The cells of lowest level, i.e. those which are not further decomposed, are called leaf cells. These generally consist of arrays of simular cells.

The above mentioned graphics editor programme GERT is used in the chip building phase and serves to introduce the real circuit layout in the leaf cells. During the rest of this phase the chip is gradually built up by means of data already provided by the user in the chip planning phase. This layout is stored in a file NGDF of the data base DB.

The routing programme RO is a programme which may be used to create routes between the above mentioned functional cells.

Instead of being used in an interactive way the programme CPBP may also be controlled from a command file provided by the procedural layout programme PLO, as will be explained later.

In what follows each cell which is placed in another cell is considered as an instance of the definition of the first mentioned cell. The cell definition is independent from the placement, whereas the instance is dependent from this placement. Therefore the elements constituting the cell definition are defined with respect to the cell itself, whereas the elements defining the instance are defined with respect to the cell definition wherein this cell instance is placed.

A cell definition may include an outline, terminals on that outline, and inside this outline connections and cuts.

The cell instances are defined by their position and orientation inside the cell definition wherein they are placed. They may be arranged in arrays and the terminals as well as the cuts may be assembled in busses. For a better understanding the definitions of certain terms used above are given hereafter:

- an outline is a closed polygon comprising horizontal and vertical line segments and enclosing all the other elements of a cell definition. This outline is defined by the coordinates of the vertices of the polygon and is therefore called point outline. The polygon also encloses a set of contiguous squares or rectangles, called boxes, covering the surface of the cell and called box outline;

- a terminal is a location on the point outline of a cell where a connection can be made. It is defined by its position on this outline and by layout information i.e. the chip layer on which it has to be realised, a direction and a width. By direction is meant : input, output or bidirectional;

- a cut is a junction point of the two chip layers located inside the outline. It is defined by its position in the cell and by the two chip layers (layout information);

- a connection is an electrical path between two endpoints each of which may be a terminal or a cut. It is defined by a centerline comprising horizontal and vertical line segments, the name of the net to which it belongs, and layout information, i.e. chip layer on which it has to be realised and its width;

- a net is an entity which identifies a set of interconnected terminals or cuts,

- a bus consists of a set of terminals, cuts or connections having the same characteristics;

- an array consists of a set of like cell instances which may be simultaneously placed in a cell definition.

Reference is now made to Fig. 2 which shows the two upper levels of a hierarchical plan of a multi-layer chip including several functional levels. This plan is realised by means of the above described system. The top level of this chip plan comprises the cell definition which has the name DN = C1 and which is constituted by the chip itself. This cell has no instance since it is not placed in another cell definition. Cell definition C1 has a point outline POL defined by the vertices P1 to P4, terminals T11 to T13 on that outline, and inside this outline a cut CU11 and connections to be considered later. Two instances, with names IN = CI21 and IN = CI31, of cell definitions C2 and C3 are placed inside the cell definition C1. They form part of a second hierarchical level of the cell plan. The cell definition of the cell instance CI21 has a point outline POL defined by the vertices P5 to P10 and terminals T21 and T22 on that outline, whilst the cell definition of the cell instance CI31 has a point outline POL defined by the vertices P11 to P14 and terminals T31 and T32 on that outline. The cell definition of the cell CI21 also has an outline defined by the contiguous boxes B21, B22 and B23 covering the surface of this cell.

It should be noted that the vertices and terminals are numbered in anti-clockwise direction.

The above mentioned connections in the cell definition C1 are made between the terminals of this cell, on the one hand, and cuts of this cell and terminals of instances placed in that cell, on the other hand.  For instance, as shown in Fig. 2, the following connections or routes are realised in the cell definition C1:

- a vertical connection T11 CU11;
- a vertical connection T12 T21;
- a horizontal connection T13 T22;
- a horizontal connection T21 CU11; and
- a connection comprising vertical and horizontal line segments CU11, P15, P16, P17 and T32.

The chip plan shown in Fig. 2 may be gradually built up by the execution of the interactive programme CPBP, as will be described later.  During this execution the data base DB is gradually constructed in such a way that it reflects the hierarchical plan of the chip. Indeed, the DB comprises a plurality of records corresponding to the above mentioned elements of a cell, i.e.:

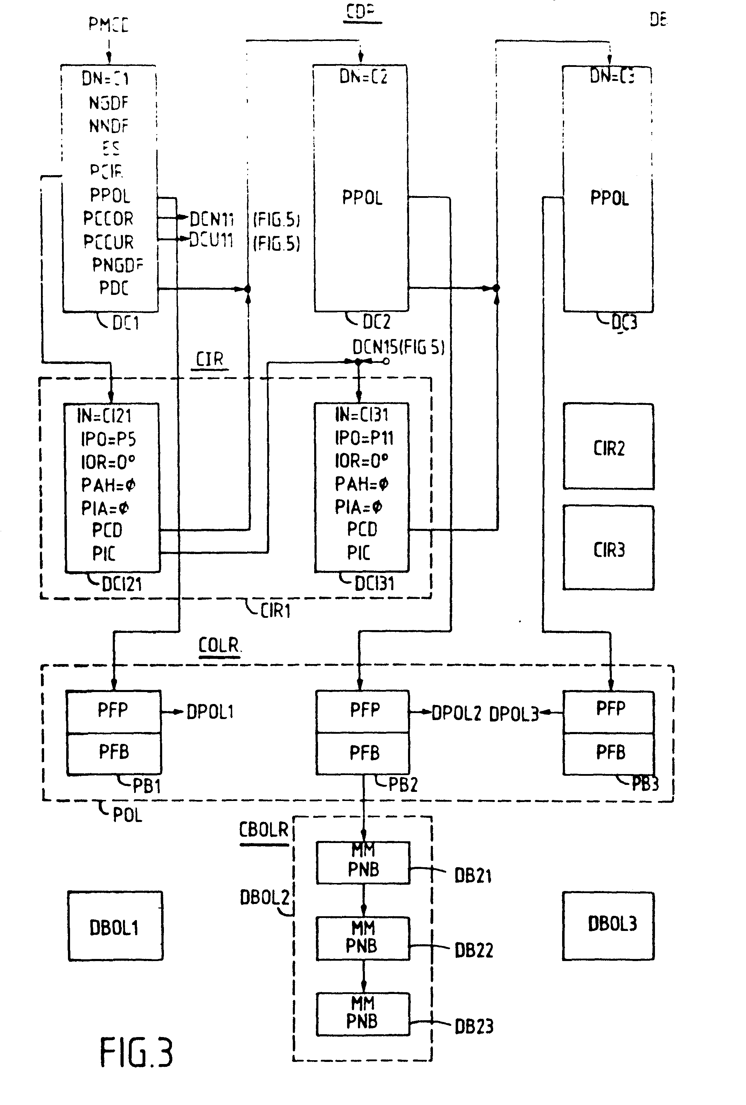

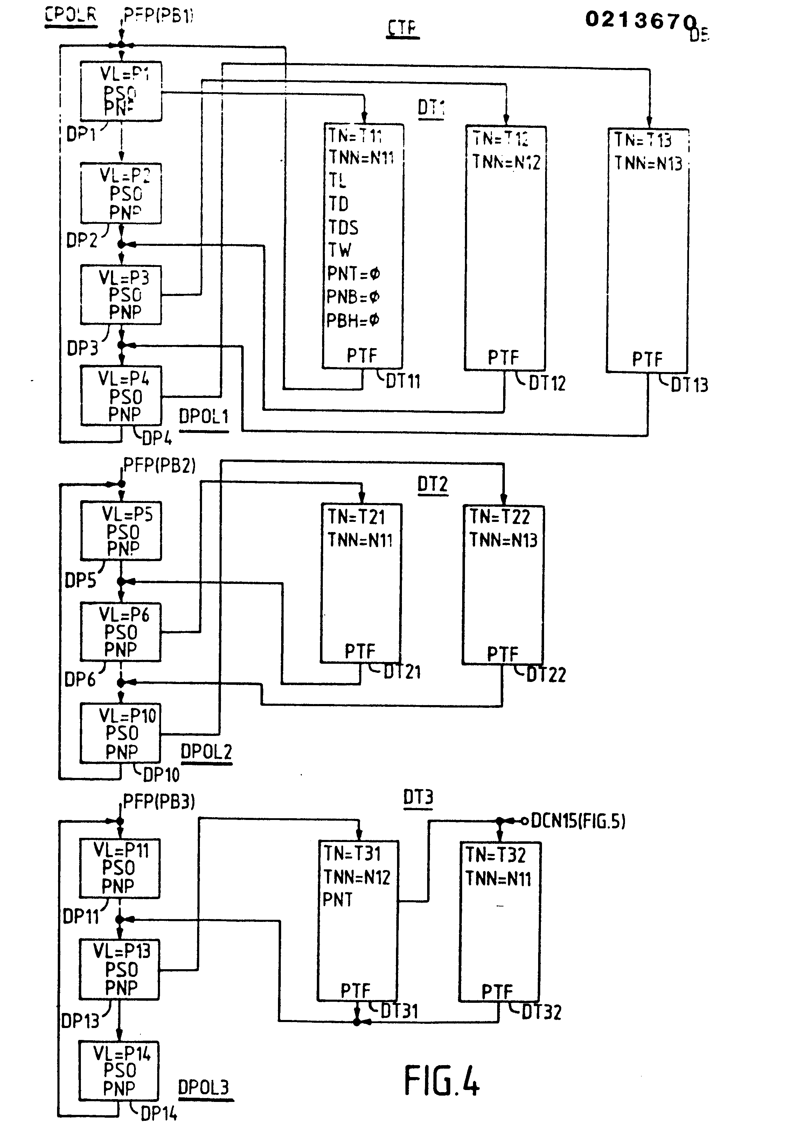

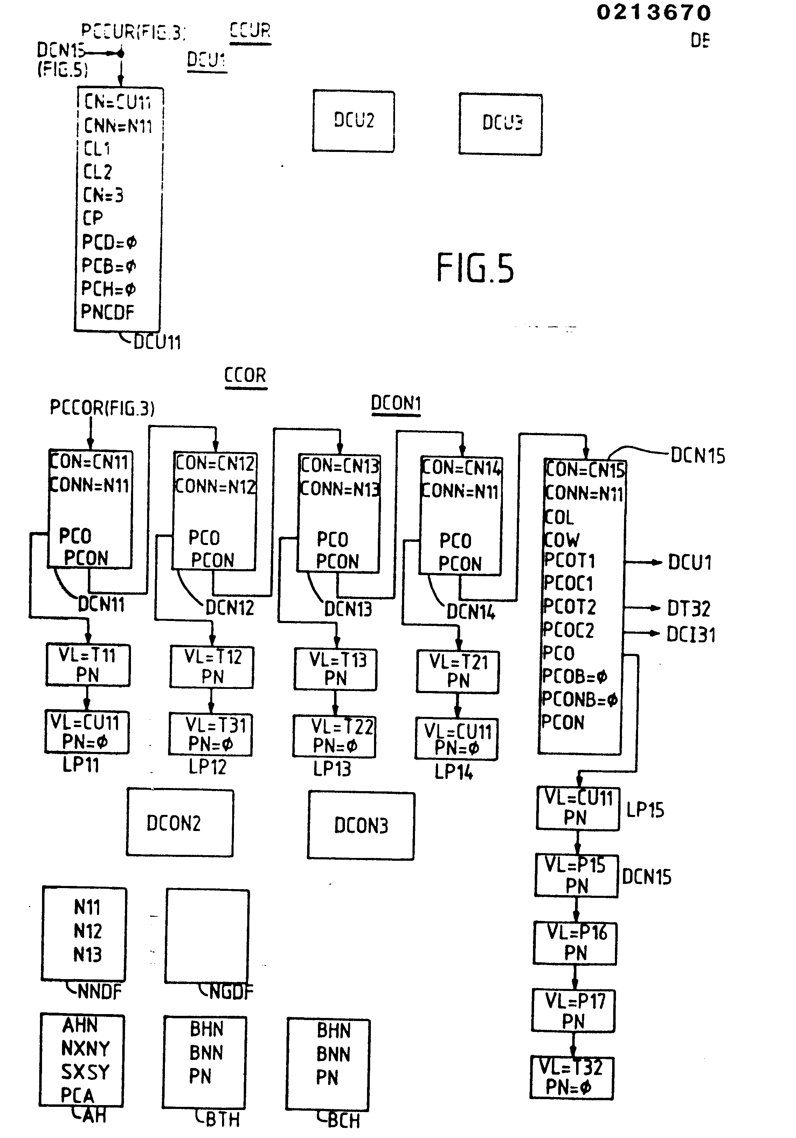

- a Cell Definition Record CDR (Fig. 3);
- a Cell Instance Record CIR (Fig. 3);
- a Cell Outline Record COR (Figs. 3, 4) comprising
    a Cell Point Outline Record CPOLR (Fig. 4),
    a Cell Box Outline Record CBOLR (Fig. 3), and
    a Pointer Block for the outline POL (Fig. 3);
- a Cell Terminal Record CTR (Fig. 4);
- a Cell Cut Record CCUR (Fig. 5); and
- a Cell Connection Record CCOR (Fig. 5).

The data stored in the record CIR relate to the placement of cell definitions as instances in other cell definitions.  On the contrary, the data stored in the other data records relate to elements of cell definitions which are independent from such a placement.

The data base DB further includes or may include the following data blocks:

- a NNDF (Fig. 5) which is a file storing a net list for each of the cell definitions;

- a NGDF (Fig. 5) which is a file storing for each of the cells of lowest level, i.e. for the so called leaf cells (not shown in Fig. 2), the layout of this cell;

- an array header AH (Fig. 5) for each array of instances. This header is a data block storing data about this array.

- a bus terminal header BTH (Fig. 5) for each bus of terminals. This header is a data block storing data concerning the bus;

- a bus cut header BCH (Fig. 5) for each bus of cuts. It is a data block storing data about this bus.

The above data records and stores also include pointers by means of which they are interlinked. The function of each of the pointers is schematically indicated by a line leading to the data block to which it refers. The contents of these records and stores are considered hereinafter for the chip plan represented in Fig. 2. Therein absent or false data are indicated by 0.

The Cell Definition Record CDR (Fig. 3)

This record comprises the cell definition data blocks DC1, DC2 and DC3 which store data concerning the respective cell definitions C1, C2 and C3 and various pointers to datablocks concerning elements of these definitions. For each cell definition these data are the following:

DN      : the name C1/3 of the cell definition;

NGDF  : the name of the NGDF;

NNDF  : the name of the NNDF;

ES      : the estimated size of the cell definition, i.e. the estimated number of transistors;

PCIR   : a pointer to the data block, in the CIR, associated to the first instance of another cell definition placed in the present cell definition;

PPOL  : a pointer to a pointer block POL for the outline of the cell definition;

PCCOR : a pointer to the data block, in the CCOR, associated to the first connection in the cell definition;

PCCUR : a pointer to the data block, in the CCUR, associated to the first cut in the cell definition;

PNGDF : a pointer to a corresponding location, of the NGDF, containing the layout of the cell definition;

PDC : a pointer to the next cell definition data block in the CDR.

The Cell Instance Record CIR (Fig. 3)

This record may comprise sets CIR1, CIR2, CIR3 of interlinked instance data blocks which store data relating to the cell instances placed in the respective cell definitions C1, C2 and C3. The data stored in each data block of such a set are the following:

IN : the name of the cell instance;

IPO : the position of the cell instance in the cell definition;

IOR : the orientation (0° or 90 °with respect to the x-axis) of the instance in the cell definition;

PAH : a pointer to an array header relating to an array of instances of which the cell instance forms part;

PIA : a pointer to the following instance data block in the array;

PCD : a pointer to the cell definition data block of the instance;

PIC : a pointer to the following cell instance data block of the set.

The Cell Outline Record COLR (Figs. 3, 4)

As already mentioned above, this record comprises a Cell Point Outline Record CPOLR, a Cell Box Outline

- 11 -

Record CBOLR, and a Pointer Record POL for the Outline.

The Cell Point Outline Record CPOLR (Fig. 4)

This record comprises the sets of point outline data blocks DPOL1, DPOL2 and DPOL3 which store data relating to the point outlines of the respective cell definitions C1, C2 and C3. Each of the data blocks of a set stores the following data for a point of the cell definition point outline defined by this set:

VL : the coordinates of this point in its own cell definition, i.e. with respect to the left bottom point of this cell which is given the coordinates 0,0;

PSO : a pointer to the first data block of the corresponding series of data blocks of the Record CTR. This series stores data concerning the terminals located between this point and the next on the outline. This will become clear after consideration of the CTR;

PNP : a pointer to the next data block of the set, the last data block of the set pointing to the first.

The Cell Box Outline Record CBOLR (Fig. 3)

This record may comprise sets DBOL1, DBOL2 and DBOL3 of box outline data blocks which store data concerning the box outlines of the respective cell definitions C1, C2 and C3. Each of the data blocks of a set stores the following data for a box of the cell box outline defined by this set:

MM : the coordinates of the left bottom and top right points of this box in its own cell definition, i.e. again with respect to the left bottom point of this cell;

PNB : a pointer to the next data block of the set of box outline data blocks.

The Pointer Record (POL) for the Outline (Fig. 3)

This record comprises the pointer blocks PB1, PB2 and PB3 which are associated to the respective cell definitions C1, C2 and C3 and which store each the following pointers:

PFP : a pointer to the first data block of the corresponding set DPOL1/3 of point outline data blocks;

PFB : a pointer to the first data block of the corresponding set DBOL1/3 of box outline data blocks.

The Cell Terminal Record CTR (Fig. 4)

This record comprises sets DT1, DT2 and DT3 of terminal data blocks which store data concerning the terminals on the point outline of the respective cell definitions C1, C2 and C3. In each of these sets the data blocks associated to terminals of a series located between two successive points of the outline are interlinked. Each of the data blocks of a set stores the following data for each terminal on this outline:

TN : the name of the terminal;

TNN : the name of the net to which the terminal belongs in the cell definition;

TL : the chip layer in which the terminal has to be realised;

TD : the type of terminal, i.e. input, output or bidirectional;

TDS : The position of the terminal in the cell of which it forms part. This position is given by a multiple of the ratio of the distance between the terminal and a preceding vertex of the outline and the distance between this vertex and the following one on the outline, the succession of vertices being considered in anti-clockwise direction.

TW : the width of the terminal;

PNT : a pointer to the data block storing data concerning the following terminal of a same series;

PNB : a pointer to the data block storing data concerning the following terminal of a same bus;

PBH : a pointer to a bus header;

PTF : a pointer to the data block storing data concerning the vertex to which the terminal is associated.

### The Cell Cut Record CCUR (Fig. 5)

This record may comprise sets DCU1, DCU2, DCU3 of cut blocks which store data concerning cuts in the respective cell definitions C1, C2 and C3. Each of these data blocks of a set stores the following data for each cut belonging to this cell definition:

CN : the name of the cut;

CNN : the name of the net to which the cut belongs;

CL1 : the first of the two layers between which a junction point or cut has to be realised;

CL2 : the second of the two layers between which a junction point or cut has to be realised;

CN : the number of connections in the junction point;

CP : the position of the cut in its own cell definition;

PCD : a pointer to the data block storing data concerning the following cut in the cell definition;

PCB : a pointer to the data block storing data concerning the following cut of a same bus;

PCH : a pointer to a bus header;

PCNGDF : a pointer to the layout description of the cut in the NGDF.

### The Cell Connection Record CCOR (Fig. 5)

This record may comprise the sets DCON1, DON2 and DCON3 of connection data blocks which store data concerning connections in the corresponding cell definitions C1, C2 and C3. Each of these data blocks of a set stores the following data for each connection

- 14 -

belonging to this cell definition:

CON     : the name of the connection;

CONN    : the name of the net to which the connection
          belongs;

COL     : the chip layer in which the connection has to be
          realised;

COW     : the width of the connection;

PCOT1   : a pointer to the data block of CTR or CCUR
          storing data concerning the first endpoint
          (terminal or cut) of the connection;

PCOC1   : a pointer to the data block of CIR storing data
          concerning the cell instance to which the first
          endpoint belongs;

PCOT2   : similar to PCOT1 but for the second endpoint of
          the connection;

PCOC2   : similar to PCOC1 but for this second endpoint;

PCO     : a pointer to the first point of a list of points
          defining the connection in the cell definition;

PCOB    : a pointer to a bus header;

PCONB   : a pointer to the next connection in the bus;

PCON    : a pointer to the data block storing data
          concerning the next connection in the same cell
          definition.

The above mentioned list to which PCO refers
includes data blocks for the terminals, cuts and points
forming part of the connection. Each such data block
stores (Fig. 5):

VL : the coordinates of the point, terminal or cut in the
     cell definition;

PN : a pointer to the next block in the list.

The NNDF (Fig. 5) is a file storing a net list for
each of the cell definitions.  The net list for the cell
definition C1 comprises:

- the net N11 including T11; T21; CU11 and T32;

- the net N12 including T12 and T31;

0213670

- 15 -

- the net N13 including T13 and T22.

An array header AH (Fig. 5) contains the following data:

AHN  : the name of the array;

NXNY : the number of instances in the x- and y-direction respectively;

SXSY : the step in the x- and y-direction, i.e. the distance between two successive instances in this direction;

PCA  : a pointer to the data block associated in CIR to the first instance of the array.

A terminal or cut bus header BTH or BCH (Fig. 5) is similar to an array header AH and includes the following data:

BHN : the name of the header;

BNN : the number of terminal or cuts forming part of the bus;

PN  : a pointer to the next terminal or cut in the bus.

The advantage of an array or bus is that it is treated as a unity so that all elements thereof may be displayed simultaneously on the DU.

From the Figs. 3 to 5 it follows that:

- CCOR (Fig. 5) includes the set DCON1 of the following data blocks concerning the connections in cell definition C1, DCON2 and DCO3 being empty:

DCN11 and list LP11 for the connection between T11 and CU11;

DCN12 and list LP12 for the connection between T12 and T31;

DCN13 and list LP13 for the connection between T13 and T22;

DCN14 and list LP14 for the connection between T21 and CU11;

DCN15 and list LP15 for the connection between CU11 and T32 via P15, P16 or P17;

- CCUR (Fig. 5) includes the set DCU1 comprising a single data block DCU11 for the cut CU11;

- CTR (Fig. 4) includes the sets DT1, DT2 and DT3 of data blocks DT11 to DT13, DT21 and DT22, and DT31 and DT32. The data blocks DT31 and DT31 are linked because T31 and T32 are both located between P13 and P14;

- POL (Fig. 3) includes the pointer blocks PB1/3 associated to the respective cell definitions C1/3;

- CPOLR (Fig. 4) includes the sets DPOL1/3 of data blocks DP1 to DP4; DP5 to DP10 and DP11 to DP14 respectively associated to the points P1-P4; P5-P10 and P11-P14 of the outlines of the cell definitions C1 to C3;

- CBOLR (Fig. 3) includes the set DBOL2 of data blocks DB21; DB22 and DB23 associated to the boxes B21; B22 and B23 of the cell definition C2. The sets DBOL1 and DBOL3 are empty;

- CIR (Fig. 3) includes the set DCIR1 of data blocks DCI21 and DCI31 associated to the instances CI21 and CI31 both placed in the cell definition C1. The sets DCIR2 and DCIR3 are empty.

- CDR (Fig. 3) comprises the data blocks DC1/3 associated to the respective cell definitions C1/3.

The various pointers refer to data blocks in the following way:

CDR : PCIR of DC1 points to DCI21;
      PPOL of DC1/3 points to PB1/3;
      PCCOR of DC1 points to DCN11;
      PCCUR of DC1 points to DCU11;
      PCD of DC1/2 points to DC2/3.

CIR : PCD of DCI21/31 points to DC2/3;
      PIC of DCI21 points to DCI31.

POL : PFP of PB1/3 points to DPOL1/3;
      PFB of PB2 points to DBOL2.

CPOLR : DPOL1 : PSO of DP1/3/4 points to DT11/12/13;
                PNP of DP1/4 points to DP2/1;
         DPOL2 : PSO of DP6/10 points to DT21/22;
                PNP of DP5/10 points to DP6/5;
         DPOL3 : PSO of DP13 points to DT3,1 whose
                pointer PNT points to DT3,2 because
                T31 and T32 are both located between
                P13 and P14.
                PNP of DP11/14 points to DP12/11.
CBOLR : DBOL2 : PNP of DB21/22 points to DB22/23.
  CTR   : DT1 : PTF of DT11/12/13 points to DP1/3/4.
          DT2 : PTF of DT21/22 points to DP6/10;
          DT3 : PTF of DT31/DT32 both point to DP13.
  CCOR  : PCO of DCN11/15 points to LP11/15;
          PCON of DCN11/14 points to LP12/15;
          PCOT1 of DCN15 points to DCU1;
          PCOC1 of DCN15 points to nothing because CU11
          does not from part of an instance;
          PCOT2 of DCN15 points to DT32;
          PCOC2 of DCN15 points to DCI31.

The pointers PCO1/2 and PCOC1/2 for DCN11/14 are not represented.

The chip plan of Fig. 2 is realised by the execution of the interactive programme CPBP and this happens briefly in the following way.

At the start of this programme and on the request thereof the user enters a plurality of parameters, such as:

LD : the layout density, expressed in number of transistors per square millimeter, e.g. 1000;

T : the technology used, e.g. CMOS;

DN : the definition name DN of the main cell which is constituted by the chip itself, e.g. DN = C1;

ES : the estimated size, i.e. the estimated number of transistors contained in the cell definition.

These parameters are stored in the data base DB. CN = Cl and ES are more particularly entered in the cell definition data block DC1 (Fig. 3). From the parameters LD and ES the programme calculates the surface of the main cell C1 and derives therefrom a square main cell which is displayed on the unit DU. The user may then either maintain this cell by digitizing the width thereof by means of the mouse or reject it. In the latter case he may either digitize a new width, the programme then calculating a new height from the surface, or he may digitize the points P1 to P4 of the outline, as is supposed here. The coordinates VL = P1 to VL = P4 (with VL = 0,0 for P1) are thereby entered in the data blocks DP1 to DP4 of the set DPOL1 forming part of the Record CPOLR (Fig. 4). The programme also starts a so-called plot outline procedure by which the main cell C1 is subdivided into a plurality of contiguous squares or rectangles, called boxes, defining the box outline. The data concerning these rectangles are stored in the Record DBOL1 (Fig. 3) as will be described further for cell instance CI2. Afterwards the point and box outlines of the main cell C1 are both displayed on the display unit DU. Only the point outline of C1 is represented in Fig. 2.

To place the cell instance CI21 of the cell definition C2 in the cell definition C1 the user then starts the execution of the instruction "Add Cell" and to this end introduces the following parameters :

DN   : C2 (the cell definition name);

IN   : CI21 (the cell instance name);

IOR  : 0° (the orientation of the instance in the cell definition C1);

IPO  : P5 (the coordinates of the origin of the instance in the cell definition C1).

The last three parameters are stored in the data block DCI21 (Fig. 3).

The user then for instance digitizes the points P5 to P10 defining the point outline of the cell definition C2, and the programme determines the box outline of this cell definition, i.e. each time with respect to P5. These outlines are then both displayed on the DU, as shown in Fig. 2, the box outline comprising the boxes B21, B22 and B23.

The coordinates VL of the digitized points P5 to P10 (with VL = 0,0 for P5) are stored in the data blocks DP5 to DP10 of the set DPOL2 forming part of the CPOLR (Fig. 4), whilst the parameters MM of the boxes B21, B22 and B23 are stored in the data blocks DB21, DB22 and DB23 of the set DBOL2 of the CBOLR (Fig. 3). As mentioned above, each MM is constituted by the coordinates of the bottom left and top right points of a box, again with respect to P5. This means that :

MM for B21 comprises the coordinates of P5 and P9;
MM for B22 comprises the coordinates of P18 and P19;
MM for B23 comprises the coordinates of P9 and P7.

To place the cell instance CI31 of the cell definition C3 in the cell definiton C1 the user proceeds in a similar way as for the cell instance CI21. As a result corresponding parameters are stored in the data blocks DCI31, DPOL3 and DBOL3. The point and box outlines of CI31 are then displayed on the DU. Fig. 2 shows the point outline of CI31.

To add the terminals T11, T12 and T13 on the point outline P1-P4 of the main cell C1 the user successively starts the execution of the following instructions :
Add terminal : used to add terminal T11 :
TN = T11 (the name of the terminal);
TL (the terminal layer);
TD (the terminal type);

TDS (the terminal position) i.e. $\dfrac{a\ P1\ T11}{P1\ P2}$ wherein a is a constant

TW  (the terminal width).

These parameters are entered in the data block DT11 Fig. 4) and the terminal T11 is displayed on DU.

Same : used to add terminal T12 which is supposed to have the same characteristics as T11 :

TN = T12;

TDS : $\dfrac{a\ P3\ T12}{P3\ P4}$

These parameters and TL, TD and TW are entered in the data block DT12 and the terminal T12 is displayed on the DU;

Same : used to add terminal T13 which is again supposed to have the same characteristics as T11 and T12 :

TN = T13

TDS : $\dfrac{a\ P4\ T13}{P4\ P1}$

These parameters and TL, TD and TW are entered in the data block DT13 and the terminal T13 is displayed on the DU.

To be noted that in the above instructions no use is made of the layout information TL, TD and TW.

The user then goes to the level of the instance CI21 by starting the execution of the instruction "Edit Cell" and digitizing a point DP (Fig. 2) in this instance CI21.  As a consequence coordinates of the digitized point DP are compared with the above mentioned coordinates MM of the boxes of both instances CI21 and CI31 and until the box is found wherein the digitized point DP is located.  In the present case it will be found that the point DP is located in box B22 forming part of the instance CI21.  This instance is then edited i.e. its outline is given a predetermined colour.

From the above follows the advantage of subdividing each cell in rectangular boxes. Indeed, the comparison of the coordinates of the digitized point DP with those of the bottom left and top right points of each of these rectangles is a relatively simple operation. Without such a subdivision it would be necessary to compare the coordinates of point DP with those of all the vertices of the cell and this might be a relatively complicated operation, especially when the cell has the shape of a complex polygon e.g. such as cell instance CI21 in Fig. 2.

In an analogous way as for the main cell C1 the terminals T21 and T22 are then added on the outline of the cell instance CI21. The corresponding parameters are stored in the data blocks DT21 and DT22 (Fig. 4).

The user then returns to the previous level i.e. to that of the main cell by executing the instruction "Quit". By this instructions the currently edited cells is left : when this cell is the main cell the user is ending his edit session, whereas otherwise the previously edited cell again becomes the currently editied cell. For this reason in the present case, the main cell C1 is again edited.

The user then again goes to the level of the instance CI31 in the same way as described above for the instance CI21 and adds terminals T31 and T32 on the outline of this instance. The corresponding parameters are stored in the data blocks DT31 and DT32 (Fig. 4).

The user then again returns to the previous level, i.e. to that of the main cell, by executing the instruction "Quit". This main cell C1 is then again edited.

To add the cut CU11 and the connections T11 CU11, T12 T31; T13 T22; T21 CU11 and CU11, P15, P16, P17, T32 to the cell definition C1, the following instructions are successively executed :

Add cut

CN   = CU11 (the cut name);

CL1 (the name of the first layer);

CL2 (the name of the second layer);

CP   (the coordinates of the cut in the cell definition
      C1).

These parameters are entered in the data block DCU11
(Fig. 5) and the cut is displayed on the DU.

Add connection : used to add the connection T1,1 CU11

CON   = CN11 (the connection name);

CONN  = N11 (the net to which the connection belongs);

COL   (the chip layer);

COW   (the width of the connection);

D1 D2 : the user digitizes the end points T1,1 and CU11,
        the coordinates of these points being given with
        respect to those of P1 of cell C1;

auto  : as a consequence the programme acts in such a way
        that the connection T11 CU11 is drawn
        automatically.

The above parameters are entered in the data block DCN11
and in the list LP11 .

The connections T12 T31, T13 T22 and T21 CU11 are
then realised and displayed in a similar way by the
execution of corresponding add instructions.  The
corresponding parameters are stored in the respective
data blocks DCN12, DCN13, DCN14 and in the respective
associated lists LP12, LP13, LP14.

Finally, an "add connection instruction" is executed
for realising and displaying the connection CU11 T31,
it being supposed that the points of this connection are
digitized.  The data entered for this instruction are:

CON   : CN15;

CONN  : N11;

COL

COW

D1 D2 : obtained by digitizing the end points CU11 and
        T21;

D3 D4 D5 : obtained by digitizing the intermediate
           points P17; P16 and P15.

These parameters are stored in the data blocks DCN15 and in the associated LP15 and the connection is displayed on the DU.

From the above it follows that the plan of the chip is generally, but not completely, built from a higher level to a lowel level. Indeed, now and then one returns to the higher level.

The other (not shown) levels of the hierarchic chip plan are then realized in a similar way until the level of the so-called leaf cells is reached. The real layout of the thus planned chip is then made in the course of the chip building phase. During a first step of this phase the layout of the leaf cells is introduced in these cells under the control of the programme GERT, this layout being for instance taken from the location of the NGDF indicated by the pointer PNGDF stored in the cell definition data block. During the following steps the layout is further completed by making use of the layout information concerning terminals, cuts and connections already stored in the data base DB during the chip plan phase, i.e. TL, TD, TW; CL1, CL2; COL, COW.

From the above also follows that the structure of the chip plan is reflected in the structure of the data base DB since for each cell with its point and box outlines, its terminals, its cuts and its instances, corresponding data blocks are provided. In this way the storage and retrieval of data concerning a cell is simplified and made more reliable.

Moreover, the data stored for each cell are split up in :

- 24 -

- data which are function of the cell definition and therefore independent from the placement of the cell in another cell :

  e.g. for cell C1 : DC1, DPOL1, DT1, DCU11, DCON1;

  for cell C2 : DC2, DPOL2, DBOL2, DT2;

  for cell C3 : DC3, DPOL3, DT3;

- data which are dependent from this placement :

  e.g. for cell C2 : DCI21;

  for cell C3 : DCI31.

As a consequence the data to be changed in the data base DB when the plan of the chip is modified is minimized. For instance, when the placement of the instance CI31 in the cell definition C1 is changed by a "Move origin instruction" i.e. by replacing the cell origin P11 to another point P'11, so that the cell instance CI'31 with outline P'11-P'14 is obtained, the following must be executed in the data base DB :

- for cell C3 :

  = nothing has to be changed to the data in the various data blocks which relate to the definition of this cell, i.e. DC3, DPOL3 and DT3, since the coordinates of the points P'11 to P'14 and of the terminals T'31 and T'32 are the same;

  = only the data stored in data block DCI31 have to be changed since the coordinates of P'11 in the cell definition C1 are different from that of P11 in the same cell definition.

- for cell C1 :

  only the data concerning the connections T12 T31 and CU11 P15 P16 P17 T32 have to be modified, i.e.

  - in LP12 the coordinates of T31 have to be replaced by those of the new points P'20, P'21 and of new terminal T'31;

  - in LP15 the coordinates of P'17 and T'32 have to be substituted for those of P17 and T32.

From the above it follows that in case of a displacement of an instance the shape of a connection might be modified but that the connection itself is maintained.

Another advantage of the describer data base structure is that it contains net information which may be used to check if the connections which have finally been realized are those indicated by the net information.

Instead of making the plan of a chip by interaction of the user and the programme CPBP, such as described above, it is also possible to run the programme CPBP from a first command file containing commands written in a relatively high level language. These commands are interpreted by the so-called procedural layout programme PLO which then generates a second command file. The commands of this file are written in a lower level language which can be immediately used by the CPBP.

An example is given hereinafter of how two cell instances A1 and B1 of the cell definitions A and B are made to abut in the upward direction.

The first command file includes the following commands :

add-abut-cell   DN=A; IN=A1; IOP=X,Y; IOR=0 °; up
continue-abut-cell   DN=B; IN=B1
end-abut-cell

These commands are interpreted by the PLO which recognizes the variables :

DN as cell name;

IN as instance name;

IOP as position (x,y);

IOR as orientation;

up as upward;

By means of the following instructions the PLO

- 26 -

creates the second command file :

- for the command 'add abut cell' :

    write ('add abut cell', cell name, instance name) write (orientation, x, y, upward)

- for the command 'continue abut cell' :

    write (cell name, instance name, orientation)

- for the command 'end abut cell' write ('end')

    The second command file thus obtained is :

    add abut cell A A1

    O X Y u

    B B1 O

    end

    In case two cells instances are made to abut in the way described above, the CPBP always asks the user if for these instances terminals coincide. In the affirmative it creates for these coinciding terminals in the data base a connection data block with an associated list of the type DCN15 and LP15 respectively. However, the latter list now obviously only includes a single point. The advantage of proceeding in this way is that when the two instances are displaced away from each other by a predetermined instruction, the CPBP maintains the connection between the previously coinciding terminals, just as was the case in the above described example wherein the origin of CI31 was displaced. Thus a method is provided to automatically realise a connection between two instances : one makes the instances to abut in such a way that terminals thereof coincide and then moves these instances away from each other.

    While the principles of the invention have been described above in connection with specific apparatus, it is to be clearly understood that this description is made only by way of example and not as a limitation on the scope of the invention.

- 27 -

CLAIMS

1. Computer aided design system for a device, e.g. chip including a display unit (DU) and a computer (COMP) having a memory (MEM) storing a data base (DB), said system enabling said device to be built up in hierarchical levels by means of a plurality of functional cells (C1, C2, C3) and such that each cell (C2), except one (C1), is placed in another cell (C1), characterized in that said data base (DB) includes, for each cell (C2), at least one definition data block (DC2, DPOL2, DBOL2, DT2) determining the definition of said cell and exclusively storing data which define said cell and are independent from its placement in said other cell, and at least one instance data block (DCI21) defining the instance of said cell and exclusively storing data which are dependent from said placement.

2. Computer aided design system according to claim 1, characterized in that the data stored in said instance data block (DCI21) relate to the name (IN) of the instance, the position (IPO) and orientation (IOR) of said cell instance (C2) in said other cell (C1) and a pointer (PCD) to the definition data block (DC2) of said other cell (C1).

3. Computer aided design system according to claim 1, characterized in that a number of definition data blocks (DC1, PPOLI, DTI, DCUI, DCONI) is associated to each cell definition (C1), and that in respective ones of said blocks data are stored concerning the cell definition proper, the outline of said cell definition, the terminals on said outline and the junction points and connections inside said outline, all said parameters being determined with respect to the cell itself.

4. Computer aided design system according to claim 3, characterized in that a first definition data block (DC1) includes at least one of the following data concerning the definition proper : the name (DN) of the cell definition (C1), the estimated size (ES) thereof, and a pointer (PNGDF) to a predetermined data block (NGDF) containing the layout of the cell definition.

5. Computer aided design system according to claim 3, characterized in that the outline of a cell definition (C2) comprises a closed polygon (P5/10) with perpendicular line segments crossing in vertices (P5/P10), and that a second definition data block (DPOL2) includes data concerning said outline which is constituted by the coordinates of said vertices.

6. Computer aided design system according to claim 5, characterized in that said outline also encloses a set of contiguous rectangles (B21/B23) covering the whole cell and the vertices (P5/10, P18/19) of which include those of the cell, and that a third definition data block (DBOL2) includes data concerning each of said rectangles (B21/23), said data being constituted by the coordinates (P5/9, P18/19, P9/7) of the vertices of a diagonal of said rectangle.

7. Computer aided design according to claim 5, characterized in that a fourth definition data block (DT3) includes data concerning terminals on the outline of the cell definition, said data being constituted by the position (TDS) of each terminal (T31) with respect to the two vertices (P13/14) of the line segment on which it is situated.

8. Computer aided design system according to claim 7, characterized in that said fourth definition data block includes for each terminal (T31) a pointer (PTF) to the second definition data block (DP13) wherein data concerning one (P13) of the two (P13, P14) associated vertices of said line segment are stored, and that said second definition data block (DPOL3, DP13) also contains a pointer (PSO) to said fourth definition data block (DT3, DT31).

9. Computer aided design system according to claim 7, characterized in that said fourth data block (DT3) also contains for each terminal the following layout information when said device is a multi-layer chip : the layer (TL) in which the terminal has to be realised, the width (TW) of the connection and its type (TD), said type indicating whether the terminal is an input, output or a bidirectional terminal.

10. Computer aided design system according to claim 7, characterized in that said fourth data block (DT3) also includes for each terminal net information (TNN) indicating to which net the terminal belongs.

11. Computer aided design system according to claim 3, characterized in that when said device is a multilayer chip, a fifth definition data block (DCU1) includes data concerning each junction point or cut (CU11) inside the outline of the cell definition, said data being constituted by layout information indicating between which layers (CL1, CL2) the junction point has to be laid.

12. Computer aided design system according to claim 11, characterized in that said fifth definition data block (DCU11) also contains net information (CNN) indicating to which net the junction point (CU11) belongs.

13. Computer aided design system according to claim 3, characterized in that a sixth definition data block (DCN15, LP15) includes data concerning each connection inside the outline of the cell definition (C1), said data being constituted by the coordinates of the various points (CU11, P15/P17, T32) of the connection and for each end point by a first pointer (PCOT1/2) to the fourth (DT32) or fifth (DCU1) data block wherein data concerning said endpoint (CU11, T32) are stored and by a second pointer (PCOC1/2) to an instance data block (DCI31) wherein data are stored concerning the instance to which this endpoint belongs.

14. Computer aided design system according to claim 13, characterized in that when said device is a multilayer chip, said sixth definition data block also contains layout information indicating the layer (COL) wherein the connection has to be made as well as the width (COW) of this connection.

15. Computer aided design according to claim 14, characterized in that said sixth definition block also stores net information (CONN) indicating to which net the the connection belongs.

16. Computer aided design system according to claim 3, characterized in that the terminals/junction points form a bus and that the data base (DB) includes a data block (BTA/BCH) wherein the number (BNN) of terminals/junction points is indicated.

17. Computer aided design system according to claim 1, characterized in that in said other cell a two-dimensional array of various same one cells is placed, and that said data base (DB) contains an array header (AH) indicating the number (NXNY) of one cells as well as the step length (SXSY) between said cells in two perpendicular directions.

18. Computer aided design system according to claim 3, characterized in that when displacing said cell in the other cell the connections in said other cell remain the same.

19. Computer aided design system according to claims 4, 9, 11 and 14, characterized in that said data base (DB) is built up in a planning phase during which layout information concerning terminals, junctions points and connections is entered in corresponding data blocks, and that said planning phase is followed by a building or layout phase during which use is made of said layout information and of layout information stored in said predetermined data block (NGDF).

20. Computer aided design system according to claims 10, 11, 15 and 19, characterized in that said net information is used to check after the planning if the connections have been realised correctly.

21. Computer aided design system according to claim 1, characterized in that said data base (DB) is built up under the control of a first programme (CPBP) which is executed from a first command file written in a relatively high level language, said commands being interpreted by a second programme (PLO) which then creates a second command file which is written in a lower level language and may be used immediately by said first programme (CPBP).

22. Computer aided design system for a device, e.g. a chip, including a display unit (DU), a computer (COMP) with a memory and means (M) to display a point (DP) on said display unit and to enter the coordinates of said point in said memory said system being able to create and display one or more first polygon-shaped cells in a second polygon-shaped cell and said cells being constituted by perpendicular line segments, characterized in that said system is adapted to first subdivide each of said first cells in one or more inner rectangles and to store the coordinates of the vertices of a diagonal of each rectangle in memory and then to compare said coordinates with those of said point (DP) until the rectangle and therefore the first cell is possibly found wherein said point is located.

FIG.1

FIG.2

FIG.3

0213670 DE

CPOLR  PFP(PB1)  CTF

VL=P1 PSO PNP  
DP1

VL=P2 PSO PNP  
DP2

VL=P3 PSO PNP  
DP3

VL=P4 PSO PNP  
DPOL1  DP4

DT1

TN=T11  
TNN=N11  
TL  
TD  
TDS  
TW  
PNT=∅  
PNB=∅  
PBH=∅  
PTF  
DT11

TN=T12  
TNN=N12  
PTF  
DT12

TN=T13  
TNN=N13  
PTF  
DT13

PFP(PB2)  DT2

VL=P5 PSO PNP  
DP5

VL=P6 PSO PNP  
DP6

VL=P10 PSO PNP  
DPOL2  DP10

TN=T21  
TNN=N11  
PTF  
DT21

TN=T22  
TNN=N13  
PTF  
DT22

PFP(PB3)  DT3

VL=P11 PSO PNP  
DP11

VL=P13 PSO PNP  
DP13

VL=P14 PSO PNP  
DPOL3  DP14

DCN15(FIG.5)

TN=T31  
TNN=N12  
PNT  
PTF  
DT31

TN=T32  
TNN=N11  
PTF  
DT32

FIG.4

PCCUR(FIG.3)  CCUR

DCN15
(FIG.5)

**FIG.5**

DCU1

CN=CU11
CNN=N11
CL1
CL2
CN=3
CP
PCD=ϕ
PCB=ϕ
PCH=ϕ
PNCDF
└ DCU11

DCU2

DCU3

CCOR

PCCOR(FIG.3)

DCON1

DCN15

| CON=CN11 | CON=CN12 | CON=CN13 | CON=CN14 | CON=CN15 |
| CONN=N11 | CONN=N12 | CONN=N13 | CONN=N11 | CONN=N11 |

COL
COW
PCOT1 → DCU1
PCOC1
PCOT2 → DT32
PCOC2 → DCI31
PCO

PCO        PCO        PCO        PCO
PCON       PCON       PCON       PCON

└DCN11      └DCN12     └DCN13     └DCN14

PCOB=ϕ
PCONB=ϕ
PCON

VL=T11     VL=T12     VL=T13     VL=T21
PN         PN         PN         PN

VL=CU11    VL=T31     VL=T22     VL=CU11
PN=ϕ       PN=ϕ       PN=ϕ       PN=ϕ
LP11       LP12       LP13       LP14

VL=CU11    LP15
PN

DCON2      DCON3

VL=P15    DCN15
PN

N11
N12
N13
└NNDF

└NGDF

VL=P16
PN

VL=P17
PN

AHN        BHN        BHN
NXNY       BNN        BNN
SXSY       PN         PN
PCA
└AH        └BTH       └BCH

VL=T32
PN=ϕ